(19) Europäisches Patentamt
European Patent Office
Office européen des brevets

(11) **EP 4 404 465 A1**

(12) **EUROPEAN PATENT APPLICATION**
published in accordance with Art. 153(4) EPC

(43) Date of publication:
**24.07.2024 Bulletin 2024/30**

(21) Application number: **22883850.4**

(22) Date of filing: **11.10.2022**

(51) International Patent Classification (IPC):
**H03K 17/16** (2006.01)    **H03K 17/284** (2006.01)
**H02H 7/20** (2006.01)

(52) Cooperative Patent Classification (CPC):
**H02H 7/20; H03K 17/16; H03K 17/284**

(86) International application number:
**PCT/KR2022/015314**

(87) International publication number:
**WO 2023/068627 (27.04.2023 Gazette 2023/17)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.10.2021   KR 20210138622
27.09.2022   KR 20220122387**

(71) Applicant: **IUCF-HYU (INDUSTRY-UNIVERSITY
COOPERATION
FOUNDATION HANYANG UNIVERSITY)**
Seoul 04763 (KR)

(72) Inventors:
 • **KIM, Raeyoung**
  **Seoul 04763 (KR)**
 • **MIN, Sungsoo**
  **Seoul 04763 (KR)**

(74) Representative: **Prüfer & Partner mbB
Patentanwälte · Rechtsanwälte
Sohnckestraße 12
81479 München (DE)**

(54)    **SHORT-CIRCUIT PROTECTION DEVICE FOR SWITCH**

(57)    Disclosed is a short-circuit protection device for a switch. The short-circuit protection device according to a first embodiment of the present invention may include: a voltage measurement unit configured to measure an output voltage of the switch and output the output voltage as a measured voltage; a filter unit configured to filter the measured voltage to a specified bandwidth and output a first voltage; and a comparison unit configured to compare a specified reference voltage with the first voltage.

[FIG. 2]

**Description**

CROSS-REFERENCE TO RELATED APPLICATION

This application claims the benefit of Korean Patent Application No. 1 0-2021-0138622, filed on October 18, 2021, and Korean Patent Application No. 10-2022-0122387, filed on September 27, 2022, and PCT application No, PCT/KR2022/015314 filed on October 11, 2022 in the Korean Intellectual Property Office, the disclosures of which are incorporated herein in its entirety by reference.

TECHNICAL FIELD

The present invention relates to a short-circuit protection device for a switch, and more particularly, to a short-circuit protection device for a switch that detects a short circuit in the switch and protects the switch.

BACKGROUND ART

Power devices are semiconductor devices that convert or control power, and rectifier diodes, power transistors, triacs, etc. are used in various fields such as industry, information, communication, transportation, power, and home. Representative power devices include metal oxide semiconductor field effect transistors (MOSFETs), insulated gate bipolar transistors (IGBTs), bipolar junction transistors (BJTs), and power integrated circuits (ICs), and among these, MOSFETs, which enable high-speed switching and have low driving circuit losses, are attracting particular attention.

In order for MOSFETs to be applied to various applications, device stability needs to be ensured. In particular, if a short circuit occurs in a MOSFET switch, the MOSFET switch may break down within hundreds of nanoseconds, so a device that can quickly determine whether a switch is short-circuited is needed.

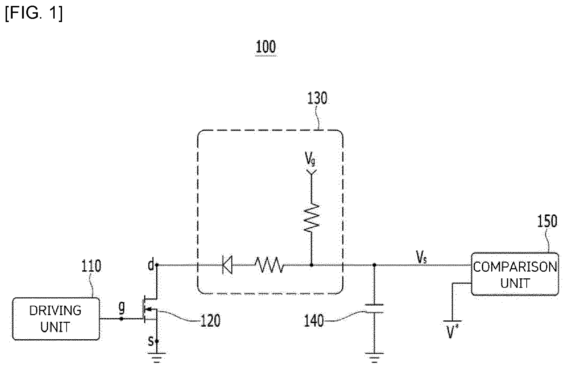

FIG. 1 is a view of a short-circuit protection circuit of a power switch, according to the prior art.

Referring to FIG. 1, a short-circuit protection circuit 100 of a power switch 120 according to the prior art may measure a drain voltage of the power switch 120 in a voltage measurement unit 130 and output a measured voltage, Vs, through a capacitor 140. In addition, a comparison unit 150 may compare the measured voltage, Vs, with a preset reference voltage, V*, and when the measured voltage, Vs, is greater than or equal to the reference voltage, V*, may determine that the power switch 120 is short-circuited.

Because the short-circuit protection circuit 100 of the power switch 120 according to the prior art measures a drain voltage of the power switch 120, the short-circuit protection circuit 100 is vulnerable to noise caused by changes in a drain voltage generated during a switching operation of the power switch 120.

This noise may be added to the measured voltage, Vs, measured by the voltage measurement unit 130, causing the measured voltage, Vs, to be greater than the reference voltage, V*, even though the power switch 120 is operating normally. This may cause malfunctions of the short-circuit protection circuit 100.

To reduce these malfunctions, a method may be considered to increase the size of the capacitor 140 to slow the rate at which the measured voltage, Vs, increases and to reduce the influence of noise generated in a switching transient state of the power switch 120. However, this method slows down the rate at which the measured voltage, Vs, increases even when the power switch 120 is short-circuited, which means that a short-circuit protection speed slows down, which may result in a break-down of the power switch 120.

Therefore, in the short-circuit protection circuit 100 according to the prior art, resistance to noise and short-circuit protection speed performance are a trade-off, and there is a problem in that it is difficult to satisfy both.

Because the measured voltage, Vs, which is an output of the voltage measurement unit 130 of the prior art, depends on the drain voltage of the power switch 120, if the drain voltage of the power switch 120 is too small, the measured voltage, Vs, may also form a small value. In this case, in order to determine a short-circuit, the reference voltage, V*, of the comparison unit 150 must also inevitably be set to a small value, which reduces a margin between the reference voltage, V*, and the measured voltage Vs, making the short-circuit protection circuit 100 vulnerable to external noise.

The matters described in the technical section forming the background of the present invention are for understanding the background of the present invention, and cannot be assumed to be prior art already known to one of ordinary skill in the art.

DESCRIPTION OF EMBODIMENTS

TECHNICAL PROBLEM

The present invention provides a short-circuit protection device for a switch capable of preventing a break-down of the switch by detecting a rapidly rising drain voltage as a measured voltage and quickly turning off the switch when a short circuit occurs in the switch.

Furthermore, the present invention provides a short-circuit protection device for a switch capable of increasing resistance to noise by attenuating high-frequency noise included in the measured voltage.

In addition, the present invention provides a short-circuit protection device for a switch capable of maintaining a sufficient margin by amplifying a drain voltage with a specified gain and setting the reference voltage to a sufficiently large value when the drain voltage is small.

SOLUTION TO PROBLEM

According to one aspect of the present invention, provided is a device for detecting and protecting a short circuit of a switch, the device including: a voltage measurement unit that measures an output voltage of the switch and outputs the output voltage as a measured voltage; a filter unit that filters the measured voltage to a specified bandwidth and outputs a first voltage; and a comparison unit that compares a specified reference voltage with the first voltage.

According to an embodiment, the filter unit may include one or more of a band-pass filter capable of passing only a specified frequency range and a low-pass filter capable of filtering components equal to or greater than a specified bandwidth.

According to an embodiment, the short-circuit protection device for a switch may further include an amplifying unit that amplifies the first voltage with a pre-specified gain and outputs the amplified voltage as a second voltage in order to adjust a margin between the first voltage and the reference voltage, wherein the comparison unit may compare the second voltage with the reference voltage.

According to an embodiment, the voltage measurement unit may include a diode in which a cathode is connected to an output terminal of the switch, a first resistor in which one end is connected to an anode of the diode, and a second resistor connecting the other end of the first resistor to a pre-determined power supply Vg, wherein the voltage measurement unit may output a voltage at the other end of the first resistor as the measured voltage.

According to an embodiment, the filter unit may include a third resistor in which one end is connected to the other end of the first resistor, and a capacitor connecting the other end of the third resistor to a pre-determined ground, wherein the filter unit may output a voltage applied to the capacitor as the first voltage.

According to an embodiment, the amplifying unit may include an amplifier that the other end of the third resistor is a first input terminal (+) of the amplifier, a fourth resistor connecting an output terminal of the amplifier to a second input terminal (-) of the amplifier, and a fifth resistor connecting the second input terminal (-) of the amplifier to a pre-determined ground, wherein the amplifying unit may output an voltage at an output terminal of the amplifier as the second voltage.

According to an embodiment, the switch may be a power switch, and the output voltage may be a drain voltage of the power switch.

According to an embodiment, the device may further include a gate driving unit that supplies driving power to a gate of the power switch, and a control unit that controls the gate driving unit to turn on or turn off the power switch according to an output of the comparison unit.

ADVANTAGEOUS EFFECTS OF DISCLOSURE

When a short circuit occurs in a switch, a short-circuit protection device for a switch according to an embodiment of the present invention may detect a rapidly rising drain voltage as a measured voltage and quickly turn off the switch, thereby preventing a break-down of the switch.

In addition, the short-circuit protection device for a switch according to an embodiment of the present invention may increase resistance to noise by attenuating high-frequency noise included in the measured voltage.

Furthermore, when the drain voltage is small, the short-circuit protection device for a switch according to an embodiment of the present invention may amplify the drain voltage with a specified gain and set a reference voltage to a sufficiently large value to maintain a sufficient margin.

BRIEF DESCRIPTION OF DRAWINGS

FIG. 1 is an exemplary view of a short-circuit protection circuit for a power switch, according to the prior art.
FIG. 2 is a view illustrating a short-circuit protection device according to a first embodiment of the present invention.
FIG. 3 is a circuit diagram illustrating a short-circuit protection device according to the first embodiment of the present invention.
FIG. 4 is a simulation result of a short-circuit protection circuit according to the prior art and a short-circuit protection device according to the first embodiment of the present invention.
FIG. 5 is a view illustrating a short-circuit protection device according to a second embodiment of the present invention.
FIG. 6 is a simulation result of a short-circuit protection circuit according to the prior art and a short-circuit protection device according to the second embodiment of the present invention.

MODE OF DISCLOSURE

Since the present invention may have diverse modified embodiments, preferred embodiments are illustrated in the drawings and are described in the detailed description. However, this is not intended to limit the present invention to particular modes of practice, and it is to be appreciated that all changes, equivalents, and substitutes that do not depart from the spirit and technical scope of the present invention are encompassed in the present invention.

In the description of the present invention, certain detailed explanations of the related art are omitted when it is deemed that they may unnecessarily obscure the essence of the present invention. In addition, numeral figures (e.g., 1, 2, and the like) used during describing the specification are just identification symbols for distinguishing one element from another element.

Further, in the specification, if it is described that one element is "connected" or "accesses" the other element, it is understood that the one element may be directly connected to or may directly access the other element but unless explicitly described to the contrary, another element may be "connected" or "access" between the elements.

In addition, it will be understood that when a unit is referred to as "comprising" another element, it may not exclude the other element but may further include the other element unless specifically oppositely indicated. In addition, terms such as "... unit", "... module", or the like refer to units that perform at least one function or operation, and the units may be implemented as one or more hardware or software or as a combination of hardware and software.

Reference will now be made in detail to embodiments, examples of which are illustrated in the accompanying drawings.

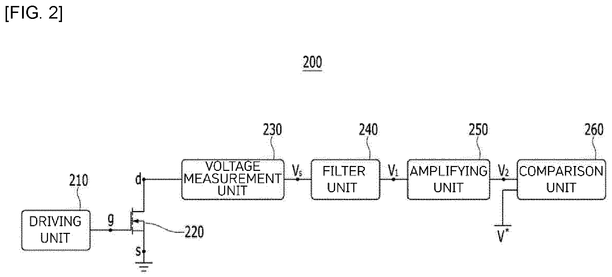

FIG. 2 is a view illustrating a short-circuit protection device (hereinafter referred to as 'short-circuit protection device') according to a first embodiment of the present invention.

Referring to FIG. 2, a short-circuit protection device 200 according to the first embodiment of the present invention may include a voltage measurement unit 230, a filter unit 240, an amplifying unit 250, and a comparison unit 260.

Hereinafter, in explaining the present invention, a switch 220 is illustrated as a power switch using a MOSFET, but a switch to which the present invention can be applied is not limited thereto. For example, the switch may be a variety of switches using a metal oxide semiconductor field effect transistor (MOSFET), an insulated gate bipolar transistor (IGBT), a bipolar junction transistor (BJT), or a power integrated circuit (IC).

A driving unit 210 may be configured to supply power to the switch 220. For example, if the switch 220 is a MOSFET, the driving unit 210 may provide gate power to the switch 220, and the MOSFET supplied with the gate power may be turned on, so that the switch 220 may be turned on. The driving unit 210 may be provided in various ways so that the switch 220 can be turned on/off.

The voltage measurement unit 230 according to a first embodiment of the present invention may measure an output voltage of the switch 220 and output the output voltage as a measured voltage Vs.

For example, if the switch 220 is a power switch implemented as a MOSFET, when the driving unit 210 provides a pre-determined power to a gate of the MOSFET, which is the switch 220, the switch 220 is conducted and a current flows through the switch 220, and a voltage may be applied to the switch 220 by internal resistance (conduction resistance) of the switch 220. The voltage measurement unit 230 may measure a drain voltage of the switch 220 and output the drain voltage as the measured voltage Vs.

The filter unit 240 according to the first embodiment of the present invention may receive the measured voltage, Vs, filter it to a specified bandwidth, and output it as a first voltage, V1.

If a short circuit occurs in the switch 220, the switch 220 may break down within hundreds of nanoseconds, so the short-circuit protection device 200 must be able to quickly determine whether the switch 220 is short-circuited.

To this end, the filter unit 240 may have a bandwidth capable of passing the measured voltage, Vs, which increases rapidly when the switch 220 is short-circuited, and at the same time filtering out high-frequency noise generated during a switching operation.

For example, the filter unit 240 may be a band-pass filter that allows only a specified frequency range to pass, or a low-pass filter that allows only low frequency components to pass.

For example, the filter unit 240 may include one or more of a passive filter such as a first-order RC low-pass filter, a second-order RC low-pass filter, a second-order RLC low-pass filter, and a second-order RC band-pass filter, and an active filter such as a first-order RC active low-pass filter with an embedded amplifier, and a Sellan-Key filter.

According to the first embodiment of the present invention, high-frequency noise included in the measured voltage, Vs, due to changes in a drain voltage that occurs during a switching operation of the switch 220 is attenuated by the filter unit 240, thereby preventing malfunctions of the short-circuit protection device 200 during a normal operation of the switch 220.

The amplifying unit 250 may amplify the first voltage, V1, by a pre-specified amplification ratio (hereinafter referred to as 'gain') and output it as a second voltage, V2.

Similar to the filter unit 240, the amplifying unit 250 may have a sufficient bandwidth to pass the measured voltage, Vs, which increases rapidly when the switch 220 is short-circuited. Therefore, the short-circuit protection device 200 according to an embodiment of the present invention may recognize that a short circuit has occurred in the switch 220 by recognizing the measured voltage, Vs, that increases rapidly when a short circuit occurs in the switch 220, and may quickly protect the switch 220.

For example, the amplifying unit 250 may be any one of various amplifiers known at the time of filing the present invention, such as an inverting/non-inverting amplifier using an amplifier (e.g., OP-AMP).

For example, depending on the characteristics of the switch 220, the amplifying unit 250 may be used as a voltage follower with a gain of 1.

As described above, the amplifying unit 250 may amplify the first voltage, V1, with a pre-specified gain and outputs it as the second voltage, V2, thereby adjusting a margin between the second voltage, V2, and the reference voltage, V*.

Hereinafter, it will be described in detail.

The short-circuit protection device 200 needs to maintain a margin between the measured voltage, Vs, and the reference voltage, V*, at a pre-determined level or higher to prevent erroneous detection of a short circuit due to noise in the switch 220 and/or noise caused by external factors.

According to the short-circuit protection circuit 100 of the prior art illustrated in FIG. 1, in a situation where a drain voltage of the switch 120 (in FIG. 1) has a small value, the reference voltage, V*, is inevitably set to a small value, and as a result, the margin between the measured voltage, Vs, and the reference voltage, V*, may become small. In this case, even with small noise, the measured voltage Vs may exceed the reference voltage, V*, causing the short-circuit protection circuit 100 (in FIG. 1) to mistakenly believe that the switch 120 is short-circuited, even though the switch 120 (in FIG. 1) is operating normally.

The amplifying unit 250 according to the first embodiment of the present invention amplifies the first voltage, V1, which is an output voltage of the filter unit 240, with a specified gain and outputs it as the second voltage, V2, so that the second voltage, V2, which is an input voltage of the comparison unit 260, may form a relatively larger voltage even in a situation where the drain voltage of the switch 220 has a small value. In this case, as a result, the margin between the second voltage, V2, and the reference voltage, V*, increases, and the short-circuit protection device 200 according to the first embodiment of the present invention has the advantage of having higher resistance to external noise.

The comparison unit 260 according to the first embodiment of the present invention may compare the second voltage, V2, with the reference voltage, V*. Here, a value output by the comparison unit 260 when the second voltage, V2, is less than the reference voltage, V*, and a value output by the comparison unit 260 when the second voltage, V2, is greater than or equal to the reference voltage, V*, may be set differently. Because of this, the short-circuit protection device 200 may determine whether the switch 220 is short-circuited through the output values of the comparison unit 260.

The driving unit 210 may turn on/off a power switch by supplying driving power to the power switch, and this may be one of various configurations known at the time of filing the present invention.

In addition, the short-circuit protection device 200 according to the first embodiment of the present invention may include a control unit (not shown) that controls the driving unit 210 according to the output value of the comparison unit 260 and consequently turns the switch 220 on or off. Here, the control unit (not shown) may be implemented as a software module integrated into any one of the above-described configurations, or may be implemented as a separate hardware independent configuration, and may be provided in various ways depending on the environment to which the present invention is applied.

Therefore, when a short circuit occurs in the switch 220, the short-circuit protection device 200 according to a first embodiment of the present invention may, first, prevent a break-down of the switch 220 by detecting a rapidly rising drain voltage as the measured voltage, Vs, and quickly turning off the switch 220, second, increase resistance to noise by attenuating the high-frequency noise included in the measured voltage, Vs, and third, maintain a sufficient margin by amplifying the drain voltage with a specified gain and setting the reference voltage, V*, to a sufficiently large value when the drain voltage is a small value.

So far, each configuration and function of the short-circuit protection device 200 according to the first embodiment of the present invention has been described with reference to FIG. 2. However, the configuration illustrated in FIG. 2 is only one embodiment of the present invention, and regardless of the name of the configuration included in the short-circuit protection device 200, depending on the environment to which the present invention is applied, it will be apparent to one of skill in the art in light of the technical idea of the present invention that the functions performed can be further subdivided and implemented with more components, or the functions performed can be combined and implemented with a smaller number of components.

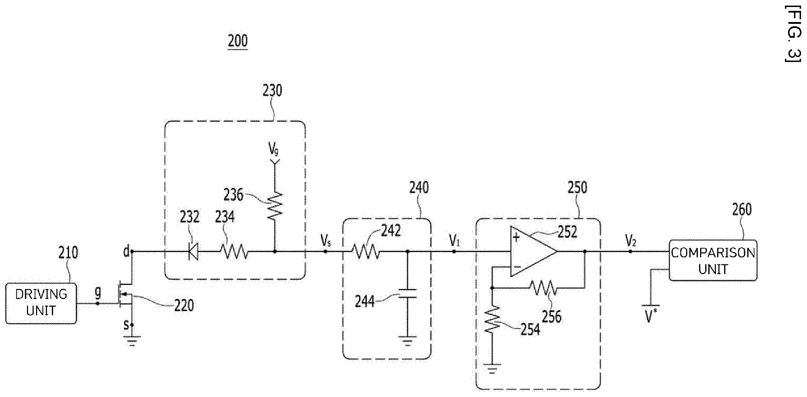

FIG. 3 is a circuit diagram illustrating a short-circuit protection device according to the first embodiment of the present invention.

Referring to FIG. 3, the voltage measurement unit 230, the filter unit 240, the amplifying unit 250, and the comparison unit 260 included in the short-circuit protection device 200 according to the first embodiment of the present invention are the same as those previously described with reference to FIG. 2, so duplicate descriptions will be omitted, and an embodiment of a circuit that can be implemented in each configuration will be described.

For example, the voltage measurement unit 230 may include a diode 232 in which a cathode is connected to an output terminal of the switch 220, a first resistor 234 in which one end is connected to an anode of the diode 232, and a second resistor 236 connecting the other end of the first resistor 234 to the pre-determined power supply, Vg. Here, the voltage measurement unit 230 may output a voltage at the other end of the first resistor 234 as the measured voltage, Vs.

For example, the measured voltage, Vs, may be calculated using Equation 1 below.

【Equation 1】

$$Vs = Vg - (Vg - Vds - Vd\_f) \times R1/(R1+R2)$$

Where Vs is the measured voltage, Vg is a pre-determined supply voltage, Vds is a voltage between a drain and source of the switch 220, Vd_f is a forward voltage drop value in the diode 232, R1 is a resistance value of the first resistor 234, and R2 is a resistance value of the second resistor 236.

Equation 1 described above is only an example, and it will be apparent to one of skill in the art in light of the technical idea of the present invention that a method of calculating the measured voltage, Vs, may be specified in various ways depending on the environment to which the present invention is applied.

The filter unit 240 may include, for example, a third resistor 242 in which one end is connected to the other end of the first resistor 234, and a capacitor 244 connecting the other end of the third resistor 242 to a pre-determined ground, wherein the filter unit 240 may output a voltage applied to the capacitor 244 as the first voltage, V1. The filter unit 240 in FIG. 3 is illustrated as a first-order RC low-pass filter, but it will be apparent to one of skill in the art in light of the technical idea of the present invention that the filter unit 240 may include one or more of various passive filters and active filters known at the time of filing of the present invention.

The amplifying unit 250 may include, for example, an amplifier 252 that the other end of the third resistor 242 is a first input terminal (+) of the amplifier, a fourth resistor 256 connecting an output terminal and a second input terminal (-) of the amplifier 252, and a fifth resistor 254 connecting the second input terminal (-) of the amplifier 252 to a pre-determined ground, wherein the amplifying unit 250 may output a voltage at the output terminal of the amplifier 252 as the second voltage, V2. The amplifying unit 250 in FIG. 3 is illustrated as a non-inverting amplifier, but it will be apparent to one of skill in the art in light of the technical idea of the present invention that the amplifying unit 250 may include various inverting/non-inverting amplifiers known at the time of filing the present invention.

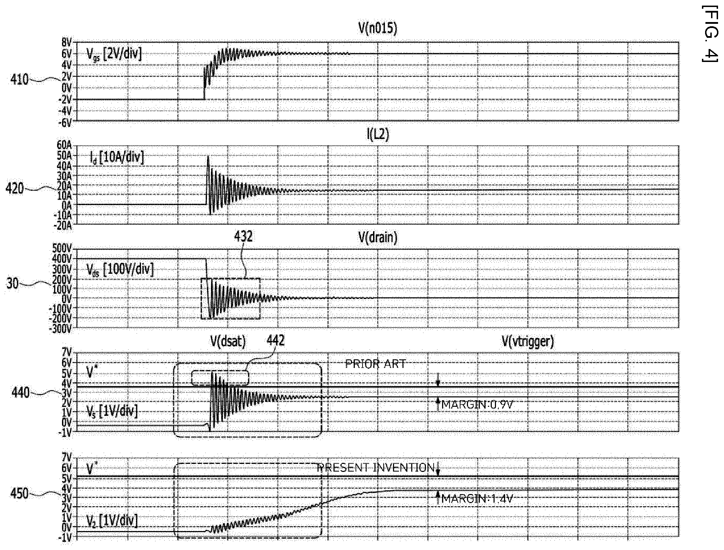

FIG. 4 is a simulation result of a short-circuit protection circuit according to the prior art and a short-circuit protection device according to the first embodiment of the present invention.

Referring to FIGS. 1, 3 and 4, when a pre-determined voltage is provided (see 410 in FIG. 4) by driving units 110 and 210 to turn on the switches 120 and 220, the drain-source voltage, Vds, may decrease (see 430 in FIG. 4).

Here, especially when the switches 120 and 220 switch at high speed, Vds rapidly decreases, which may cause undershoot and/or ringing in Vds (see 432 in FIG. 4).

In the short-circuit protection circuit 100 according to the prior art illustrated in FIG. 1, a current due to ringing of Vds flows in the capacitor 140 (in FIG. 1), so that the measured voltage, Vs, may exceed the reference voltage, V*, even though the switch 120 is not in a short-circuit state (see 442 in FIG. 4). As a result, in the short-circuit protection circuit 100 according to the prior art, a malfunction may occur in which the switch 120 is determined to be short-circuited even though the switch 120 is operating normally.

However, referring to a simulation result (see 450 in FIG. 4) of the short-circuit protection device 200 according to the first embodiment of the present invention, it can be seen that compared to the measured voltage Vs (see 440 in FIG. 4) of the prior art, the second voltage, V2, (see 450 in FIG. 4) is hardly affected and has strong resistance to noise.

In addition, it can be seen that the amplifying unit 250 is provided, and a margin between a voltage (in more detail, the measured voltage, Vs, in the prior art, and the second voltage, V2, in the first embodiment) input to the comparison unit 260 and the reference voltage, V*, is increased to 1.4V in the first embodiment compared to 0.9V in the prior art, thereby improving resistance to external noise.

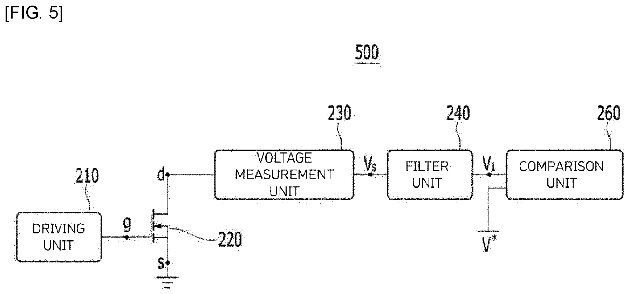

FIG. 5 is a view illustrating a short-circuit protection device according to a second embodiment of the present invention.

Referring to FIG. 5, in the short-circuit protection device 200 according to the first embodiment of the present invention described above with reference to FIG. 2, the amplifying unit 250 is omitted depending on the environment to which the present invention is applied.

For example, as detailed previously, when the filter unit 240 includes one or more active filters such as a first-order RC active low-pass filter with an embedded amplifier and a Sallen-Key filter, the output is amplified with a specified gain, so the amplifying unit 250 illustrated in FIG. 2 may be omitted.

For example, when a drain voltage of the switch 220 has a sufficiently large value, the reference voltage, V*, may also be set to a sufficiently large value. In this case, because a margin between the first voltage, V1, and the reference voltage, V*, input to the comparison unit 260 may be maintained constant, the amplifying unit 250 may be omitted.

In addition, it will be apparent to one of ordinary skill in the art in light of the technical idea of the present invention that the amplifying unit 250 may be omitted due to various purposes (e.g., the need to be implemented in a relatively smaller size, lower cost, shorter production time, etc.) depending on the environment to which the present invention is applied.

When described with reference to FIG. 5, except that the comparison unit 260 compares the first voltage, V1, with the reference voltage, V*, it is the same as that described with reference to FIG. 2, so a redundant description thereof will be omitted.

In addition, a short-circuit protection device 500 according to the second embodiment of the present invention may be illustrated by, for example, omitting the amplifying unit 250 from the circuit illustrated in FIG. 3, and because this has been described in detail previously in FIG. 3, a redundant description thereof will be omitted.

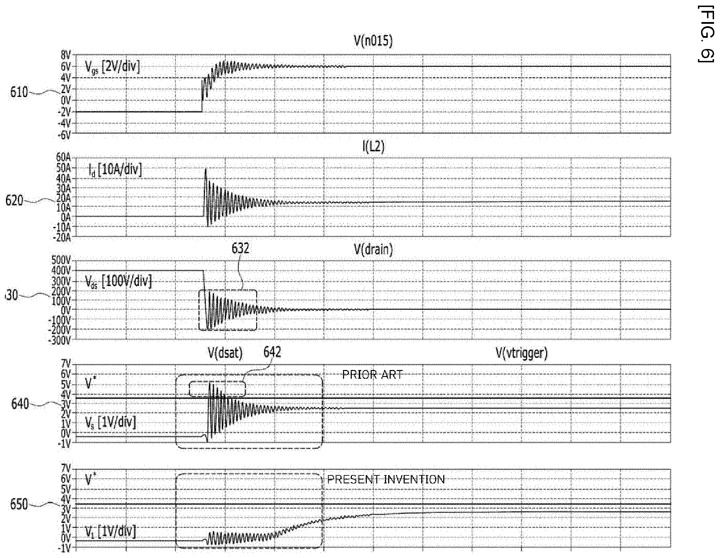

FIG. 6 is a simulation result of a short-circuit protection circuit according to the prior art and a short-circuit protection device according to the second embodiment of the present invention.

Referring to FIGS. 1, 4, 5, and 6, in the short-circuit protection circuit 100 according to the prior art, the fact that the short-circuit protection circuit 100 may malfunction due to ringing of Vds, which is a voltage between drain and source of the switch 120, is the same as previously explained with reference to FIG. 4, and thus a redundant description thereof will be omitted.

In addition, in the short-circuit protection device 500 according to the second embodiment of the present invention, as illustrated by reference number 650 in FIG. 6, it can be seen that the first voltage, V1, output by the filter unit 240 by removing high-frequency noise is not significantly affected by ringing of Vds, which is the voltage between the drain and source of the switch 120, and shows improved resistance to noise.

While the embodiments of the present invention have been particularly shown and described, it will be understood by one of ordinary skill in the art that various changes in form and details may be made therein without departing from the spirit and scope of the disclosure as defined by the appended claims.

**Claims**

1. A device for detecting and protecting a short circuit of a switch, the device comprising:

   a voltage measurement unit configured to measure an output voltage of the switch and output the output voltage as a measured voltage;
   a filter unit configured to filter the measured voltage to a specified bandwidth and output the filtered voltage as a first voltage; and
   a comparison unit configured to compare the first voltage with a specified reference voltage.

2. The device of claim 1, wherein the filter unit comprises:
   one or more of a band-pass filter capable of passing only a specified frequency range and a low-pass filter capable of filtering components equal to or greater than a specified bandwidth.

3. The device of claim 1, further comprising:

   an amplifying unit configured to amplify the first voltage with a pre-specified gain and output the amplified voltage as a second voltage in order to adjust a margin between the first voltage and the reference voltage,
   wherein the comparison unit compares the second voltage with the reference voltage.

4. The device of claim 3, wherein the voltage measurement unit comprises:

   a diode in which a cathode is connected to an output terminal of the switch;
   a first resistor in which one end is connected to an anode of the diode; and
   a second resistor connecting the other end of the first resistor to a pre-determined power supply, Vg, and
   wherein the voltage measurement unit outputs a voltage at the other end of the first resistor as the measured voltage.

5. The device of claim 4, wherein the filter unit comprises:

   a third resistor in which one end is connected to the other end of the first resistor; and
   a capacitor connecting the other end of the third resistor to a pre-determined ground, and
   wherein the filter unitoutputs a voltage applied to the capacitor as the first voltage.

6. The device of claim 5, wherein the amplifying unit comprises:

   an amplifier that the other end of the third resistor is a first input terminal (+) of the amplifier;
   a fourth resistor connecting an output terminal of the amplifier to a second input terminal (-) of the amplifier; and
   a fifth resistor connecting the second input terminal (-) of the amplifier to a pre-determined ground,
   wherein the amplifying unit outputs an voltage at an output terminal of the amplifier as the second voltage.

7. The device of claim 1, wherein the switch is a power switch, and
   the output voltage is a drain voltage of the power switch.

8. The device of claim 7, further comprising:

   a gate driving unit configured to supply driving power to a gate of the power switch; and
   a control unit configured to control the gate driving unit to turn on or turn off the power switch according to an output of the comparison unit.

[FIG. 1]

[FIG. 2]

200

[FIG. 3]

EP 4 404 465 A1

[FIG. 4]

[FIG. 5]

[FIG. 6]

## INTERNATIONAL SEARCH REPORT

| International application No. |
|---|
| **PCT/KR2022/015314** |

**A. CLASSIFICATION OF SUBJECT MATTER**

**H03K 17/16**(2006.01)i; **H03K 17/284**(2006.01)i; **H02H 7/20**(2006.01)i

According to International Patent Classification (IPC) or to both national classification and IPC

**B. FIELDS SEARCHED**

Minimum documentation searched (classification system followed by classification symbols)

H03K 17/16(2006.01); H02M 1/32(2007.01); H02M 3/157(2006.01); H02M 3/158(2006.01); H03K 17/08(2006.01); H03K 17/082(2006.01); H03K 17/687(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 스위치(switch), 단락(short), 보호(protection), 전압(voltage), 필터(filter), 대역통과필터(band pass filter), 저역통과필터(low pass filter), 기준전압(reference voltage), 임계(threshold), 비교기(comparator), 전계효과트랜지스터(field effect transistor), 모스펫(MOSFET), 마진(margin), 증폭(amplification)

**C. DOCUMENTS CONSIDERED TO BE RELEVANT**

| Category* | Citation of document, with indication, where appropriate, of the relevant passages | Relevant to claim No. |
|---|---|---|
| Y | US 2002-0130645 A1 (TSAI, Sheng-Nan et al.) 19 September 2002 (2002-09-19)<br>See paragraphs [0025]-[0028] and figure 2. | 1-2,7-8 |
| A | | 3-6 |
| Y | EP 1282231 B1 (LUTRON ELECTRONICS CO., INC.) 29 December 2004 (2004-12-29)<br>See paragraphs [0022] and [0050] and figures 2 and 7. | 1-2,7-8 |
| A | US 2019-0058402 A1 (HONEYWELL INTERNATIONAL INC.) 21 February 2019 (2019-02-21)<br>See claims 1 and 3 and figures 1-3. | 1-8 |
| A | JP 2012-227845 A (OSHIMA, Shunzo) 15 November 2012 (2012-11-15)<br>See claim 1 and figures 1-2. | 1-8 |

☑ Further documents are listed in the continuation of Box C.    ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 January 2023** | **18 January 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2022/015314**

**C.      DOCUMENTS CONSIDERED TO BE RELEVANT**

| Category* | Citation of document, with indication, where appropriate, of the relevant passages | Relevant to claim No. |
|-----------|-----------------------------------------------------------------------------------|-----------------------|
| A | KR 10-2021-0088350 A (HYUNDAI ELEVATOR CO., LTD.) 14 July 2021 (2021-07-14)<br>See claim 1 and figures 2-3. | 1-8 |

Form PCT/ISA/210 (second sheet) (July 2022)

<table>
<tr><td colspan="2" align="center"><b>INTERNATIONAL SEARCH REPORT</b><br>Information on patent family members</td><td colspan="2">International application No.<br><br><b>PCT/KR2022/015314</b></td></tr>
</table>

| Patent document cited in search report | | | Publication date (day/month/year) | Patent family member(s) | | | Publication date (day/month/year) |
|---|---|---|---|---|---|---|---|
| US | 2002-0130645 | A1 | 19 September 2002 | None | | | |
| EP | 1282231 | B1 | 29 December 2004 | AT | 249695 | T | 15 September 2003 |
| | | | | AT | 281023 | T | 15 November 2004 |
| | | | | AT | 286322 | T | 15 January 2005 |
| | | | | AU | 5609400 | A | 09 January 2001 |
| | | | | CA | 2374381 | A1 | 28 December 2000 |
| | | | | CA | 2374381 | C | 09 August 2011 |
| | | | | DE | 60005186 | T2 | 17 June 2004 |
| | | | | DE | 60015401 | T2 | 20 October 2005 |
| | | | | DE | 60017203 | T2 | 06 April 2006 |
| | | | | EP | 1188240 | A1 | 20 March 2002 |
| | | | | EP | 1188240 | B1 | 10 September 2003 |
| | | | | EP | 1282231 | A2 | 05 February 2003 |
| | | | | EP | 1282231 | A3 | 12 February 2003 |
| | | | | EP | 1283596 | A1 | 12 February 2003 |
| | | | | EP | 1283596 | B1 | 27 October 2004 |
| | | | | ES | 2206258 | T3 | 16 May 2004 |
| | | | | ES | 2231647 | T3 | 16 May 2005 |
| | | | | ES | 2236439 | T3 | 16 July 2005 |
| | | | | JP | 2003-503003 | A | 21 January 2003 |
| | | | | JP | 4159286 | B2 | 01 October 2008 |
| | | | | US | 6347028 | B1 | 12 February 2002 |
| | | | | WO | 00-79681 | A1 | 28 December 2000 |
| US | 2019-0058402 | A1 | 21 February 2019 | US | 10270347 | B2 | 23 April 2019 |
| JP | 2012-227845 | A | 15 November 2012 | None | | | |
| KR | 10-2021-0088350 | A | 14 July 2021 | KR | 10-2299582 | B1 | 08 September 2021 |

Form PCT/ISA/210 (patent family annex) (July 2022)

**EP 4 404 465 A1**

**REFERENCES CITED IN THE DESCRIPTION**

**Patent documents cited in the description**

- KR 1020210138622
- KR 1020220122387
- KR 2022015314 W